(19) **Europäisches Patentamt / European Patent Office / Office européen des brevets**

(11) **EP 1 658 670 B1**

(12) # EUROPÄISCHE PATENTSCHRIFT

(45) Veröffentlichungstag und Bekanntmachung des Hinweises auf die Patenterteilung:
**23.01.2008 Patentblatt 2008/04**

(21) Anmeldenummer: **04766586.4**

(22) Anmeldetag: **24.08.2004**

(51) Int Cl.:
**H03B 5/32** *(2006.01)*

(86) Internationale Anmeldenummer:
**PCT/EP2004/051890**

(87) Internationale Veröffentlichungsnummer:
**WO 2005/041403 (06.05.2005 Gazette 2005/18)**

(54) **OSZILLATOR MIT AKUSTISCHEN OBERFLÄCHENWELLENRESONATOREN**

OSCILLATOR WITH AN ACOUSTIC SURFACE WAVE RESONATOR

OSCILLATEUR POURVU DE RESONATEURS A ONDES DE SURFACE ACOUSTIQUES

(84) Benannte Vertragsstaaten:
**AT BE BG CH CY CZ DE DK EE ES FI FR GB GR HU IE IT LI LU MC NL PL PT RO SE SI SK TR**

(30) Priorität: **25.08.2003 DE 10339865**
**04.06.2004 DE 102004028421**

(43) Veröffentlichungstag der Anmeldung:
**24.05.2006 Patentblatt 2006/21**

(73) Patentinhaber: **Tele Filter GmbH**
**14513 Teltow (DE)**

(72) Erfinder:
• **MARTIN, Günter**
**01307 Dresden (DE)**

• **WEIHNACHT, Manfred**
**01744 Malter (DE)**

(74) Vertreter: **Rauschenbach, Dieter**
**Bienertstrasse 15**
**01187 Dresden (DE)**

(56) Entgegenhaltungen:
| DE-A- 19 818 826 | US-A- 3 701 147 |
| US-A- 3 886 484 | US-A- 3 889 205 |
| US-A- 3 894 286 | US-A- 4 193 045 |
| US-A- 4 272 742 | |

• **MARTIN G. ET AL: 'Saw resonators for temperature stable oscillators' ULTRASONICS SYMPOSIUM, 2005 IEEE Bd. 1, 18 September 2005, Seiten 446 - 449**

EP 1 658 670 B1

**Beschreibung**

Die Erfindung bezieht sich auf das Gebiet Elektrotechnik/Elektronik. Objekte, bei denen die Anwendung möglich und zweckmäßig ist, sind Bauelemente auf der Basis akustischer Oberflächenwellen wie Oszillatoren und Sensoren, insbesondere solche Sensoren, bei denen sich der Temperaturgang der Oszillatorfrequenz einstellen lässt.

Es sind Oszillatoren bekannt, die einen Verbund aus zwei frequenzbestimmenden Elementen, von denen jedes Element mindestens einen interdigitalen Wandler für akustische Oberflächenwellen enthält und eine einen Verstärker enthaltende Rückkopplung vom Ausgang zum Eingang des Verbundes umfasst, wobei die frequenzbestimmenden Elemente sich durch die Temperaturabhängigkeit der Synchronfrequenz voneinander unterscheiden.

Bei einer speziellen Ausführung enthält der Verbundaus zwei frequenzbestimmenden Elementen zwei Verzögerungsleitungen, deren Substrate ein und demselben Kristallschnitt angehören, aber verschiedene Ausbreitungsrichtungen benutzen (T. I. Browning and M. F. Lewis, "A novel technique for improving the temperature stability of SAW/SSBW devices"in Proc. 1978 IEEE Ultrasonics Symposium, S. 474 - 477 [1]). Als Kristallschnitt dient der ST-Schnitt von Quarz. Beim ST-Schnitt ist die Schnittnormale um 42,75° gegenüber der kristallografischen Y-Achse von Quarz geneigt. Das Substrat der Hauptverzögerungsleitung hat die X-Achse von Quarz als Ausbreitungsrichtung, während die Ausbreitungsrichtung der Hilfsverzögerungsleitung um 41° dazu geneigt ist. Demzufolge verschwindet bei der Hauptverzögerungsleitung der Temperaturkoeffizient der Synchronfrequenz erster Ordnung. Dagegen ist der Temperaturkoeffizient der Synchronfrequenz erster Ordnung der Hilfsverzögerungsleitung ungleich null. Trotz der unterschiedlichen Ordnungen der Temperaturkoeffizienten gelingt es, den Temperaturkoeffizienten der Synchronfrequenz zweiter Ordnung der Hauptverzögerungsleitung zu kompensieren. Der zur Kompensation des Temperaturkoeffizienten der Synchronfrequenz zweiter Ordnung der Hauptverzögerungsleitung erforderliche Temperaturkoeffizient der Synchronfrequenz erster Ordnung der Hilfsverzögerungsleitung wird als Funktion des zu kompensierenden Temperaturkoeffizienten zweiter Ordnung, der Amplitude der Hilfsverzögerungsleitung und der für beide Verzögerungsleitungen gleichen Ausbreitungsstrecke angegeben.

Im Zusammenhang mit fernabfragbaren Sensoren, die im speziellen Fall Eintorresonatoren auf der Basis akustischer Oberflächenwellen enthalten, ist es bekannt, zur Temperaturkompensation zwei Eintorresonatoren zu kombinieren, deren Substrate verschiedene Ausbreitungsrichtungen ein und desselben Kristallschnitts repräsentieren (A differential measurement SAW device for passive remote sensing,W. Buff, M. Rusko, T. Vandahl, M. Goroll und F. Möller, Proc. 1996 IEEE Ultrasonics Symposium, S. 343 - 346 [2]). Voraussetzung für die Temperaturkompensation ist dabei, dass diese Ausbreitungsrichtungen unterschiedliche Phasengeschwindigkeiten und nahezu gleiche Temperaturkoeffizienten der Synchronfrequenz haben.

Die in der Druckschrift [1] beschriebene Lösung hat folgende Nachteile:

(1) Verzögerungsleitungen mit vorgegebener Substratlänge können eine zu kleine Phasensteilheit haben, was eine ungenügende Stabilität der Oszillatoren zur Folge hat.

(2) Die Größe $|S_{21}|$ bei der Oszillatorfrequenz, die sich temperaturabhängig einstellt, ist zu stark temperaturabhängig, so dass der Verstärker in der Rückkopplung infolge eines zu großen Verstärkungsbereichs unerwünschte nichtlineare Effekte oder als geregelter Verstärker zu hohe Kosten verursacht.

(3) Die Methode der Temperaturkompensation aus [1] ist nur für breitbandige frequenzbestimmende Elemente anwendbar.

(4) Das in [1] verwendete Modell zur Beschreibung des Verbundes zweier Verzögerungsleitungen ist eine Näherung für den Fall, dass die Eingangs- bzw. Ausgangsimpedanz des Verbundes der Verzögerungsleitungen sehr groß im Vergleich mit dem Quell- bzw. Lastwiderstand ist und alle Wandler reflexionsfrei sind. Die mit Hilfe dieses Modells gewonnene Lehre, beispielsweise die oben erwähnte Funktion für den Temperaturkoeffizienten der Synchronfrequenz erster Ordnung der Hilfsverzögerungsleitung ist deshalb in vielen Fällen nicht anwendbar und nicht auf solche frequenzbestimmende Elemente übertragbar, bei denen Reflexionen eine wesentliche Rolle spielen.

Es ist auch schon eine Oszillatorschaltung bekannt, die mit einem Verbund von parallelgeschalteten Eintor-Oberflächenwellenresonatoren aufgebaut ist und bei der eine Rückkopplung vom Ausgang zum Eingang des Verbundes vorhanden ist, die einen Verstärker enthält (US 4,193,045). Diese Oszillatorschaltung funktioniert nicht ohne einen Blindwiderstand, z.B. einer Kapazität, in Reihe mit der Resonatorparallelschaltung. Da infolge der unterschiedlichen Temperaturgänge die Resonanzfrequenzen der verschiedenen Einzelresonatoren nicht im gesamten betrachteten Temperaturbereich gleich sein können, wird jede Resonanz der Parallelschaltung jeweils nur von einem einzigen Einzelresonator bestimmt, so dass keine Kompensation des Temperaturkoeffizienten der Frequenz 2. Ordnung (TKF2) infolge von Wechselwirkungen der Einzelresonatoren untereinander zustande kommt. Ohne den Blindwiderstand ist bei diesem Oszillator eine Verbesserung des Temperaturganges der Oszillatorfrequenz nicht möglich.

Der Erfindung liegt die Aufgabe zugrunde, temperaturstabile Oszillatoren mit akustischen Oberflächenwellenbauelementen als frequenzbestimmende Elemente der bekannten Art so zu verändern, dass

- die Phasensteilheit der frequenzbestimmenden Elemente bei vorgegebener Substratlänge und demzufolge die Stabilität der Oszillatoren erhöht wird,
- die Größe $|S_{21}|$ an der Oszillatorfrequenz, die sich bei der jeweiligen Temperatur einstellt, nur schwach temperaturabhängig ist und
- die frequenzbestimmenden Elemente schmalbandig sind sowie
- eine Lehre für die Gestaltung temperaturstabiler Oszillatoren anzugeben, die nicht auf einer Näherung wie in der Druckschrift [1] basiert und die auch auf solche frequenzbestimmende Elemente übertragbar ist, bei denen Reflexionen eine wesentliche Rolle spielen.

Diese Aufgabe wird dadurch gelöst, dass die frequenzbestimmenden Elemente akustische Zweitor-Oberflächenwellenresonatoren sind, die Koppelelemente zur gegenseitigen Kopplung ihrer Wellenfelder enthalten oder parallelgeschaltet sind, wobei der Temperaturkoeffizient erster Ordnung der Synchronfrequenz jedes der beiden Oberflächenwellenresonatoren ungleich null ist und sich von diesem Temperaturkoeffizienten des jeweils anderen Zweitor-Oberflächenwellenresonators im Vorzeichen unterscheidet oder wobei der Temperaturkoeffizient zweiter Ordnung der Synchronfrequenz jedes der beiden Zweitor-Oberflächenwellenresonatoren ungleich null ist und die Temperaturkoeffizienten erster Ordnung, bezogen auf eine vorgegebene Temperatur, gleich null sind.

Zweckmäßigerweise wird dabei das Verhältnis der Aperturen der interdigitalen Wandler und das Verhältnis der Längen in Richtung senkrecht zu den Zinkenkanten der interdigitalen Wandler und den Streifen der Reflektoren derjenigen Objekte verschiedener frequenzbestimmender Elemente, die infolge des Verbundes miteinander verbunden sind, so gewählt, dass die Änderung der Oszillatorfrequenz im Temperaturbereich, für den der Oszillator bestimmt ist, minimal ist.

Zweckmäßigerweise kann jedes der frequenzbestimmenden Elemente zwei interdigitale Wandler für akustische Oberflächenwellen enthalten, wobei interdigitale Wandler diejenigen Objekte sind, die infolge des Verbundes miteinander in Parallelschaltung verbunden sind.

Bei den Zweitor-Oberflächenwellenresonatoren können jeweils zwei interdigitale Wandler zwischen zwei Reflektoren angeordnet sein und die Zweitor-Oberflächenwellenresonatoren können sich durch die Apertur und den Zwischenraum zwischen den interdigitalen Wandlern unterscheiden, wobei die Aperturen, die Zwischenräume zwischen den interdigitalen Wandlern und die Synchronwellenlängen in den Zweitor-Oberflächenwellenresonatoren so gewählt sind, dass die Oszillatorfrequenz bei einer vorgegebenen Temperatur einer vorgegebenen Frequenz entspricht.

Vorteilhafterweise können die frequenzbestimmenden Elemente akustische Oberflächenwellenresonatoren sein, bei denen der interdigitale Wandler zwischen je zwei Reflektoren angeordnet ist. Hierbei enthalten die Oberflächenwellenresonatoren Koppelelemente, mit deren Hilfe eine gegenseitige Kopplung der Wellenfelder der Oberflächenwellenresonatoren hergestellt ist. Das Verhältnis der Aperturen der Wandler und das Verhältnis der Längen der Koppelelemente in Richtung senkrecht zu den Zinkenkanten der Wandler und den Streifen der Reflektoren sind dabei so gewählt, dass die Variation der Oszillatorfrequenz im gegebenen Temperaturbereich minimal ist.

Erfindungsgemäß können beide Oberflächenwellenresonatoren mit Substraten der gleichen Kristallart aufgebaut sein oder die Substrate der Oberflächenwellenresonatoren gehören verschiedenen Kristallarten an. Im Falle von Substraten der gleichen Kristallart benutzen die Oberflächenwellenresonatoren unterschiedliche Ausbreitungsrichtungen für akustische Oberflächenwellen auf ein und demselben Kristallschnitt. Im Falle verschiedener Kristallarten sind die Oberflächenwellenresonatoren auf separaten Substraten angeordnet.

Die Elektrodenstrukturen beider Oberflächenwellen-resonatoren können vorteilhaft auch auf einem gemeinsamen Substrat angeordnet sein.

Die Kristallarten, die Kristallschnitte sowie die Ausbreitungsrichtungen der Zweitor-Oberflächenwellenresonatoren für akustische Oberflächenwellen sind vorteilhaft so gewählt, dass die Temperaturabhängigkeiten $f_1(T)$ und $f_2(T)$ der Synchronfrequenz $f_1$ bzw. $f_2$ des ersten beziehungsweise zweiten Zweitor-Oberflächenwellenresonators die Gleichung

$$V\big(f_1(T),\ f_2(T)\big)\ =\ -\big(\partial\varphi\ /\ \partial f_2\big)\,/\big(\partial\varphi\ /\ \partial f_1\big)$$

erfüllen,
mit

$$V\ =\ \big(df_1\ /\ dT\big)\,/\big(df_2\ /\ dT\big)\Big|_{T\,=\,T_1}$$

oder mit

$$V = \left\lfloor (f_{1,max} - f_{1,min}) / \Delta T_1 \right\rfloor / \left\lfloor (f_{2,max} - f_{2,min}) / \Delta T_2 \right\rfloor$$

und mit

$$\Delta T_{1,2} = T_{1,2,max} - T_{1,2,min} ,$$

wobei $\varphi$ die Phase des Verbundes der Zweitor-Oberflächenwellenresonatoresonatoren, $f_{1,2,max}$ die im betrachteten Temperaturbereich maximale Synchronfrequenz des ersten beziehungsweise zweiten Zweitor-Oberflächenwellenresonators, $f_{1,2,min}$ die im betrachteten Temperaturbereich minimale Synchronfrequenz des ersten bzw. zweiten Zweitor-Oberflächenwellenresonators und $T_{1,2,max}$ und $T_{1,2,min}$ diejenigen Temperaturen sind, bei denen die entsprechenden Extremwerte der Synchronfrequenzen auftreten und $T_1$ eine Temperatur im betrachteten Temperaturbereich ist.

Zwischen den interdigitalen Wandlern wenigstens eines Zweitor-Oberflächenwellenresonators kann ein Zwischenreflektor angeordnet sein.

Einer der interdigitalen Wandler kann sich zweckmäßigerweise durch seine Polarität von den übrigen unterscheiden. Vorteilhafterweise sollte in den Zweitor-Oberflächenwellenresonatoren der Temperaturkoeffizient der Synchronfrequenz gleicher Ordnung dominieren, und zwar der Temperaturkoeffizient der Synchronfrequenz erster oder zweiter Ordnung.

Die Zweitor-Oberflächenwellenresonatoren sollten ähnliche Temperaturabhängigkeiten der Synchronfrequenz haben, wobei die Ähnlichkeit darin besteht, dass die Temperaturabhängigkeit der Synchronfrequenz des einen Zweitor-Oberflächenwellenresonators durch Multiplikation mit einem konstanten Faktor der Temperaturabhängigkeit der Synchronfrequenz des jeweils anderen Zweitor-Oberflächenwellenresonators so angenähert werden kann, dass die Differenz der Temperaturabhängigkeiten der Synchronfrequenz im gesamten betrachteten Temperaturbereich wesentlich kleiner ist als diese Temperaturabhängigkeit jeder der beiden Zweitor-Oberflächenwellenresonatoren.

Die Synchronwellenlängen in den Zweitor-Oberflächenwellenresonatoren sind so gewählt, dass die Zweitor-Oberflächenwellenresonatoren trotz unterschiedlicher Phasengeschwindigkeiten die gleiche Resonanzfrequenz haben.

Der Temperaturkoeffizient erster Ordnung der Synchronfrequenz jedes der beiden Oberflächenwellenresonatoren kann ungleich null sein und sich von diesem Temperaturkoeffizienten des jeweils anderen Oberflächenwellenresonators im Vorzeichen unterscheiden.

Auch der Temperaturkoeffizient zweiter Ordnung der Synchronfrequenz jedes der beiden Oberflächenwellenresonatoren kann ungleich null sein und sich von diesem Temperaturkoeffizienten des jeweils anderen Oberflächenwellenresonators im Vorzeichen unterscheiden, wobei die Temperaturkoeffizienten erster Ordnung, bezogen auf eine vorgegebene Temperatur, gleich null sind.

Die Oberflächenwellenresonatoren können als Koppelelement einen Koppelwandler enthalten, wobei der Koppelwandler des ersten Oberflächenwellenresonators mit dem Koppelwandler des jeweils zweiten Oberflächenwellenresonators über zwei elektrische Verbindungen miteinander verbunden ist.

Dabei können sich die Aperturen der Koppelwandlervoneinander unterscheiden und die Zinkenzahlen der Koppelwandler sind gleich. Es können sich auch die Zinkenzahlen der Koppelwandler voneinander unterscheiden, wenn die Aperturen der Koppelwandler gleich sind. Darüber hinaus können die Koppelwandler mehr Zinken enthalten als der Wandler desjenigen Oberflächenwellenresonators, zu dem der jeweilige Koppelwandler gehört.

Zwischen den elektrischen Verbindungen, welche die Koppelwandler verschiedener Oberflächenwellenresonatoren verbinden, kann eine Induktivität, bezeichnet als Koppelinduktivität, geschaltet sein.

Zwischen die elektrischen Verbindungen, welche die Koppelwandler verschiedener Oberflächenwellenresonatoren verbinden, kann auch eine Kapazität, bezeichnet als Koppelkapazität, geschaltet sein.

Zweckmäßigerweise kann mindestens einer der Koppelwandler mindestens eine Gruppe aufeinanderfolgender Zinken enthalten, welche aus einer geraden Anzahl Zinken mit gleicher Polarität besteht.

Gemäß einer vorteilhaften Ausgestaltung der Erfindung ist der Kristallschnitt ein ST-Schnitt von Quarz, wobei die Richtung senkrecht zu den Zinken der Wandler und zu den Reflektorstreifen für den einen Oberflächenwellenresonator um einen Winkel zwischen° 0 und 45° und für den anderen Oberflächenwellenresonator um einen Winkel > 45 zur kristallografischen X-Achse von Quarzgeneigt ist.

Die Koppelelemente beider Oberflächenwellenresonatoren können erfindungsgemäß einen Multistreifenkoppler bilden.

Nach einer zweckmäßigen Ausgestaltung der Erfindungsind die Zinkenperiode der Wandler, die Streifenperiode der Reflektorstreifen, die Abstände der Wandler zu den Koppelelementen und zu den Reflektoren sowie die Dicke der Elektrodenschicht der Oberflächenwellenresonatoren so gewählt, dass deren Resonanzen an einer vorgegebenen Temperatur einen vorgegebenen Frequenzabstand haben. Dabei kann der vorgegebene Frequenzabstand gleich null sein.

Die Erfindung ist nachstehend an Hand von Ausführungsbeispielen näher erläutert. Die zugehörigen Zeichnungen zeigen:

Fig. 1    ein Oszillator, bestehend aus einem Verbund von zwei frequenzbestimmenden Elementen,

Fig. 2    ein weiterer Oszillator mit zwei frequenzbestimmenden Elementen und einer Koppelinduktivität,

Fig. 3    ein weiterer Oszillator mit zwei frequenzbestimmenden Elementen, die hier auf separaten Substraten angeordnet sind.

Beispiel 1

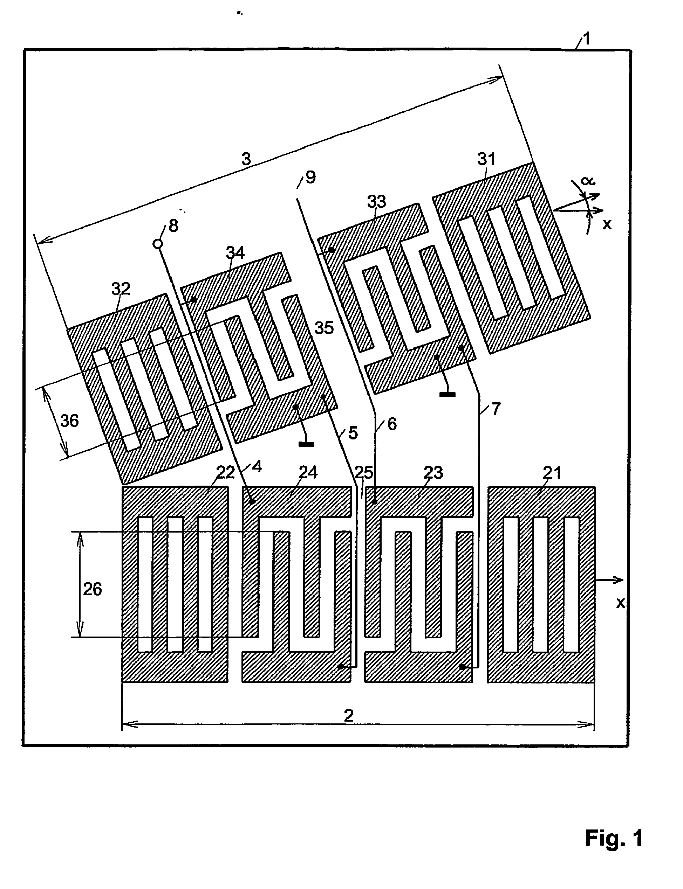

Der in Fig. 1 dargestellte Oszillator besteht aus einem Resonatorverbund als frequenzbestimmendes Element und einer in der Zeichnung nicht dargestellten Rückkopplung vom Ausgang zum Eingang des Verbundes, die einen Verstärker enthält. Die Phase dieser Rückkopplung wird als gleich Null vorausgesetzt. Im folgenden werden die Eigenschaften des Resonatorverbundes beschrieben.

Auf einem Substrat 1, das ein ST-Schnitt von Quarz ist, sind zwei Zweitor-Oberflächenwellenresonatoren 2;3, zusammengesetzt aus Reflektoren 21;22 und interdigitalen Wandlern 23;24 bzw. aus Reflektoren 31;32 und interdigitalen Wandlern 33;34, angeordnet. Die Zweitor-Oberflächenwellenresonatoren 2;3 bilden einen Resonatorverbund. Die Ausbreitungsrichtung des Zweitorresonators 2, d. h. die Richtung senkrecht zu den Zinken der Wandler 23;24 und den Streifen der Reflektoren 21;22, ist parallel zur kristallografischen x-Achse von Quarz ausgerichtet. Deshalb hat die Temperaturabhängigkeit der Synchronfrequenz des Zweitor-Oberflächenwellenresonators 2 einen Verlauf, bei dem der parabolische Anteil dominiert. Die Ausbreitungsrichtung des Zweitor-Oberflächenwellenresonators 3, das heißt, die Richtung senkrecht zu den Zinken der Wandler 33;34 und den Streifen der Reflektoren 31;32, ist um den Winkel $\alpha$ gegenüber der kristallografischen x-Achse von Quarz geneigt. Beim Verlauf der Temperaturabhängigkeit der Synchronfrequenz des Zweitor-Oberflächenwellenresonators 3 dominiert ebenfalls der parabolische Anteil. Der Wandler 23 des Zweitor-Oberflächenwellenresonators 2 und der Wandler 33 des Zweitor-Oberflächenwellenresonators 3 sind über die elektrischen Verbindungen 6;7 parallel geschaltet, während der Wandler 24 des Zweitor-Oberflächenwellenresonators 2 und der Wandler 34 des Zweitor-Oberflächenwellenresonators 3 über die elektrischen Verbindungen 4; 5 parallel geschaltet sind. Der Abstand der Mitten benachbarter Zinken und der Abstand der Mitten benachbarter Reflektorstreifen, entsprechend der Hälfte der Synchronwellenlänge, in den Zweitor-Oberflächenwellenresonatoren 2;3 sind so gewählt, dass jeweils eine Resonanzfrequenz beider Zweitor-Oberflächenwellenresonatoren 2;3 bei der gleichen Frequenz liegt. Die Parallelschaltung der Wandler 24;34 bzw. 23;33 bildet den Eingang 8 bzw. Ausgang 9 des Resonatorverbundes Der Zwischenraum 35 zwischen den Wandlern 33 und 34 des Zweitor-Oberflächenwellenresonators 3 ist größer als der Zwischenraum 25 zwischen den Wandlern 23 und 24 des Zweitor-Oberflächenwellenresonators 2 und die Apertur 36 der Wandler 33 und 34 des Zweitor-Oberflächenwellenresonators 3 ist kleiner als die Apertur 26 der Wandler 23 und 24 des Zweitor-Oberflächenwellenresonators 2.

Bei der Bestimmung der Parameter der Zweitor-Oberflächenwellenresonatoren 2;3 werden zunächst der Zwischenraum 25, die Apertur 26 und die Synchronfrequenz des Zweitor-Oberflächenwellenresonators 2 sowie der Zwischenraum 35 und die Synchronfrequenz des Zweitor-Oberflächenwellenresonators 3 gesetzt. Aus der Forderung, dass die Phase des Resonatorverbundes gleich null sein soll, wird mit Hilfe eines Nullstellensuchprogramms die Apertur 36 bestimmt. Unter Benutzung aller dieser Größen wird über die Forderung, dass die Ableitung der Oszillatorfrequenz nach der Temperatur bei einer vorgegebenen Temperatur verschwinden soll, das Verhältnis V der Temperaturableitungen der Synchronfrequenz der Zweitor-Oberflächenwellenresonatoren 2;3 aus dem Verhältnis der Ableitungen der Phase des Resonatorverbundes nach der Synchronfrequenz des Zweitor-Oberflächenwellenresonators 2 bzw. 3 nach der Gleichung

$$V = (df_1 / dT)/(df_2 / dT)\big|_{T=T_1} = -(\partial\varphi / \partial f_2)/(\partial\varphi / \partial f_1)$$

berechnet, wobei $f_1$, $f_2$ die Synchronfrequenz des Zweitor-Oberflächenwellenresonators 2 bzw. 3 und $T_1$ eine vorgegebene Temperatur ist.

Wenn das Verhältnis V nicht mit dem Verhältnis $V_0$ übereinstimmt, so wird mindestens eine der Größen Zwischenraum 25, Apertur 26, Synchronfrequenz des Zweitor-Oberflächenwellenresonators 2, Zwischenraum 35 und Synchronfrequenz des Zweitor-Oberflächenwellenresonators 3 variiert und anschließend die Apertur 36 neu bestimmt.Dabei ist $V_0$ das Verhältnis der Ableitungen der als experimentelle oder berechnete Daten vorliegenden Temperaturabhängigkeit der Synchronfrequenz für die Ausbreitungsrichtungender Zweitor-Oberflächenwellenresonatoren 2; 3. Dieses Verfahren wird solange wiederholt, bis Übereinstimmung des Verhältnisses V mit dem Verhältnis $V_0$ innerhalb eines vorgegebenen Fehlerbereichs erreicht ist. Als Ergebnis dieses Verfahrens sind alle Parameter bekannt, damit die Oszillatorfrequenz weniger temperaturabhängig ist, wenn der Resonatorverbund an Stelle eines Zweitorresonators auf der Basis akustischer Oberflächenwellen als frequenzbestimmendes Element eines Oszillators verwendet wird.

Beispiel 2

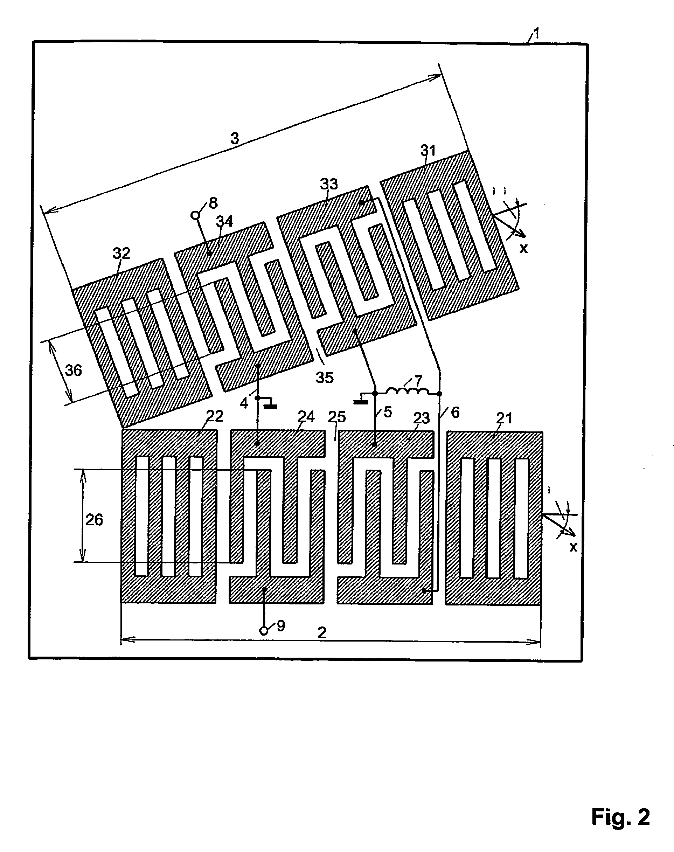

Dieses Beispiel betrifft den in Fig. 2 dargestellten Oszillator. Dieser besteht aus einem Resonatorverbund als frequenzbestimmendes Element und einer in der Zeichnung nicht dargestellten, einen Verstärker enthaltenden Rückkopplung vom Ausgang zum Eingang des Verbundes. Die Phase dieser Rückkopplung wird als gleich null vorausgesetzt. Im folgenden werden die Eigenschaften dieses Resonatorverbundes beschrieben.

Auf einem Substrat 1, das ein ST-Schnitt von Quarz ist, sind die Oberflächenwellenresonatoren 2;3, zusammengesetzt aus den Reflektoren 21;22 und dem interdigitalen Wandler 24 beziehungsweise aus den Reflektoren 31; 32 und dem interdigitalen Wandler 34, angeordnet. Außerdem ist im Oberflächenwellenresonator 2 bzw. 3 zwischen dem Wandler 24 bzw. 34 und dem Reflektor 21 bzw. 31 ein Koppelwandler 23 beziehungsweise 33 angeordnet. Die Oberflächenwellenresonatoren 2;3 bilden einen Resonatorverbund. Die Elektroden bestehen aus einer Aluminiumschicht einer Dicke von 300 nm. Die Ausbreitungsrichtung des Oberflächenwellenresonators 2, d. h. die Richtung senkrecht zu den Zinken des Koppelwandlers 23 und des Wandlers 24 und den Streifen der Reflektoren 21;22, ist um den Winkel $\alpha2$ = 30° zur kristallografischen x-Achse von Quarz geneigt. Deshalb ist der Temperaturkoeffizient erster Ordnung der Synchronfrequenz des Oberflächenwellenresonators 2 positiv. Die Ausbreitungsrichtung des Oberflächenwellenresonators 3, das heißt, die Richtung senkrecht zu den Zinken des Koppelwandlers 33 und des Wandlers 34 und den Streifen der Reflektoren 31;32, ist um den Winkel $\alpha3$ = 47,5° gegenüber der kristallografischen x-Achse von Quarz geneigt. Deshalb ist der Temperaturkoeffizient erster Ordnung der Synchronfrequenz des Oberflächenwellenresonators 3 negativ. Die Zwischenräume 25 und 35 zwischen dem Wandler 24 und dem Koppelwandler 23 des Oberflächenwellenresonators 2 bzw. dem Wandler 34 und dem Koppelwandler 33 des Oberflächenwellenresonators 3 sind gleich breit. Jeweils eine Kammelektrode des Wandlers 24 und des Wandlers 34 stehen über die am Massepotential liegende Verbindung 4 miteinander in elektrischem Kontakt. Jede Kammelektrode des Koppelwandlers 23 steht mit einer Kammelektrode des Koppelwandlers 33 über die Verbindungen 5 und 6 elektrisch in Verbindung, wobei die Verbindung 5 an das Massepotential angeschlossen ist. Zwischen die Verbindungen 5 und 6 ist eine Koppelinduktivität 7 geschaltet. Diese bildet zusammen mit den Kapazitäten der Koppelwandler 23 und 33 einen Schwingkreis. Der Wandler 34 des Oberflächenwellenresonators 3 dient als Eingang 8 und der Wandler 24 des Oberflächenwellenresonators 2 dient als Ausgang 9 des Resonatorverbundes. Die Aperturen 26 und 36 des Koppelwandlers 23 und des Wandlers 24 bzw. des Koppelwandlers 33 und des Wandlers 34 sowie die Koppelinduktivität 7 sind so gewählt, dass die Variation der Oszillatorfrequenz im gegebenen Temperaturbereich minimal ist. Der Abstand der Mitten benachbarter Zinken, der Abstand der Mitten benachbarter Reflektorstreifen, die Zwischenräume 25 und 35 zwischen dem Koppelwandler 23 und dem Wandler 24 bzw. dem Koppelwandler 33 und dem Wandler 34 und die Zwischenräume zwischen dem Koppelwandler 23 und dem Reflektor 21, dem Wandler 24 und dem Reflektor 22, dem Koppelwandler 33 und dem Reflektor 31 sowie dem Wandler 34 und dem Reflektor 32 in den Oberflächenwellenresonatoren 2;3 sind so gewählt, dass jeweils eine Resonanz beider Oberflächenwellenresonatoren 2;3 bei Raumtemperatur an der gleichen Frequenz liegt.

Der Oszillator schwingt an einer Resonanz desjenigen Resonanzpaares, das aus der Kopplung der zur jeweiligen symmetrischen Hohlraummode gehörenden Resonanzen der Oberflächenwellenresonatoren 2 und 3 resultiert. Diese Kopplung wird durch die Verbindungen 5 und 6 erzeugt. Als Resonanz des erwähnten Resonanzpaares ist diejenige ausgewählt, die zur symmetrischen Koppelmode gehört. Diese Koppelmode ist durch gleichphasige elektrische Signale der Koppelwandler 23 und 33 gekennzeichnet.

Beispiel 3

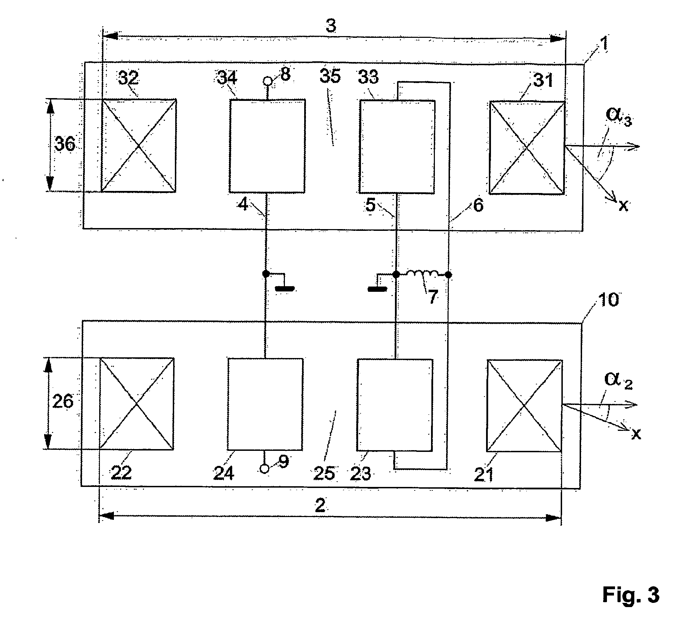

Dieses Beispiel betrifft den in Fig. 3 dargestellten Oszillator mit zwei separaten Substraten. Hierbei ist auf einem ersten Substrat 10 ein Oberflächenwellenresonator 2, zusammengesetzt aus den Reflektoren 21;22 und dem interdigitalen Wandler 24, angeordnet. Außerdem ist im Oberflächenwellenresonator 2 zwischen dem Wandler 24 und dem Reflektor 21 ein Koppelwandler 23 angeordnet. Auf einem zweiten Substrat 1 ist ein Oberflächenwellenresonator 3, zusammengesetzt aus den Reflektoren 31;32 und dem interdigitalen Wandler 34 angeordnet. Außerdem ist im Oberflächenwellenresonator 3 zwischen dem Wandler 34 und dem Reflektor 31 ein Koppelwandler 33 angeordnet. Die Oberflächenwellenresonatoren 2;3 bilden einen Resonatorverbund. Sowohl das Substrat 1 als auch das Substrat 10 ist ein ST-Schnitt von Quarz. In diesem Fall ist die Ausbreitungsrichtung des Oberflächenwellenresonators 2, das heißt die Richtung senkrecht zu den Zinken des Koppelwandlers 23 und des Wandlers 24 und den Streifen der Reflektoren 21; 22, um den Winkel $\alpha2$ = 30° zur kristallografischen x-Achse von Quarz geneigt. Deshalb ist der Temperaturkoeffizient erster Ordnung der Synchronfrequenz des Oberflächenwellenresonators 2 positiv. Die Ausbreitungsrichtung des Oberflächenwellenresonators 3, das heißt, die Richtung senkrecht zu den Zinken des Koppelwandlers 33 und des Wandlers 34 und den Streifen der Reflektoren 31;32, ist um den Winkel $\alpha 3 = 47,5°$ gegenüber der kristallografischen x-Achse des Substrats 10 geneigt. Deshalb ist der Temperaturkoeffizient erster Ordnung der Synchronfrequenz des Oberflächenwellenresonators 3 negativ.

Die Substrate 1 und 10 können aber auch Schnitte unterschiedlicher Kristallarten sein.

Die Zwischenräume 25 und 35 zwischen dem Wandler 24 und dem Koppelwandler 23 des Oberflächenwellenresonators 2 bzw. dem Wandler 34 und dem Koppelwandler 33 des Oberflächenwellenresonators 3 sind gleich breit. Jeweils eine Kammelektrode des Wandlers 24 und des Wandlers 34 stehen über die am Massepotential liegende Verbindung 4 miteinander in elektrischem Kontakt. Jede Kammelektrode des Koppelwandlers 23 steht mit einer Kammelektrode des Koppelwandlers 33 über die Verbindungen 5 und 6 elektrisch in Verbindung, wobei die Verbindung 5 an das Massepotential angeschlossen ist. Zwischen die Verbindungen 5 und 6 ist eine Koppelinduktivität 7 geschaltet. Diese bildet zusammen mit den Kapazitäten der Koppelwandler 23 und 33 einen Schwingkreis. Der Wandler 34 des Oberflächenwellenresonators 3 dient als Eingang 8 und der Wandler 24 des Oberflächenwellenresonators 2 dient als Ausgang 9 des Resonatorverbundes. Die Aperturen 26 und 36 des Koppelwandlers 23 und des Wandlers 24 bzw. des Koppelwandlers 33 und des Wandlers 34 sowie die Koppelinduktivität 7 sind so gewählt, dass die Variation der Oszillatorfrequenz im gegebenen Temperaturbereich minimal ist. Der Abstand der Mitten benachbarter Zinken, der Abstand der Mitten benachbarter Reflektorstreifen, die Zwischenräume 25 und 35 zwischen dem Koppelwandler 23 und dem Wandler 24 bzw, dem Koppelwandler 33 und dem Wandler 34 und die Zwischenräume zwischen dem Koppelwandler 23 und dem Reflektor 21, dem Wandler 24 und dem Reflektor 22, dem Koppelwandler 33 und dem Reflektor 31 sowie dem Wandler 34 und dem Reflektor 32 in den Oberflächenwellenresonatoren 2;3 sind so gewählt, dass jeweils eine Resonanz beider Oberflächenwellenresonatoren 2;3 bei Raumtemperatur an der gleichen Frequenz liegt.

**Patentansprüche**

1. Oszillator, enthaltend einen Verbund aus zwei frequenzbestimmenden Elementen, wobei jedes Element mindestens einen interdigitalen Wandler (29; 34) für akustische Oberflächenwellen enthält, und wobei eine Rückkopplung vom Ausgang (9) zum Eingang (8) des Verbundes vorhanden ist, die einen Verstärker enthält, und wobei die frequenzbestimmenden Elemente (2;3) sich durch die Temperaturabhängigkeit der Synchronfrequenz voneinander unterscheiden, **dadurch gekennzeichnet, dass** die frequenzbestimmenden Elemente akustische Zweitor-Oberflächenwellenresonatoren (2;3) sind, bei denen jeweils zwei interdigitale Wandler (23;24;33,34) zwischen zwei Reflektoren (21;22;31;32) angeordnet sind und die Zweitor-Oberflächenwellenresonatoren (2;3) die Koppelelemente (23;33) zur gegenseitigen Kopplung ihrer Wellenfelder enthalten oder in den Zweitor-Oberflächenwellenresonatoren (2;3) interdigitale Wandler diejenigen Objekte sind, die infolge des Verbundes miteinander in Parallelschaltung verbunden sind, wobei der Temperaturkoeffizient erster Ordnung der Synchronfrequenz jedes der beiden Oberflächenwellenresonatoren (2;3) ungleich null ist und sich von diesem Temperaturkoeffizienten des jeweils anderen Zweitor-Oberflächenwellenresonators im Vorzeichen unterscheidet oder wobei der Temperaturkoeffizient zweiter Ordnung der Synchronfrequenz jedes der beiden Oberflächenwellenresonatoren (2;3) ungleich null ist und die Temperaturkoeffizienten erster Ordnung, bezogen auf eine vorgegebene Temperatur, gleich null sind.

2. Oszillator nach Anspruch 1, **dadurch gekennzeichnet, dass** das Verhältnis der Aperturen der interdigtalen Wandler (24; 34) und das Verhältnis der Längen in Richtung senkrecht zu den Zinkenkanten der interdigitalen Wandler (24; 34) und den Streifen der Reflektoren (21;22;31;33) derjenigen Objekte (23;33) verschiedener frequenzbestimmender Elemente, die infolge des Verbundes miteinander verbunden sind, so gewählt sind, dass die Änderung der Oszillatorfrequenz im Temperaturbereich, für den der Oszillator bestimmt ist, minimal ist.

3. Oszillator nach Anspruch 1, **dadurch gekennzeichnet, dass** jedes der frequenzbestimmenden Elemente zwei interdigitale Wandler (23;24;33;34) für akustische Oberflächenwellen enthält, wobei interdigitale Wandler diejenigen Objekte sind, die infolge des Verbundes miteinander in Parallelschaltung verbunden sind.

4. Oszillator nach Anspruch 1, **dadurch gekennzeichnet, dass** bei den akustischen Zweitor-Oberflächenwellenresonatoren (2;3) jeweils zwei interdigitale Wandler (23;24;33;34) zwischen zwei Reflektoren (21;22;31;32) angeordnet sind und die Zweitor-Oberflächenwellenresonatoren (2;3) sich durch die Apertur (26;36) und den Zwischenraum (25;35) zwischen den interdigitalen Wandlern (23;24 bzw. 33;34) unterscheiden, wobei die Aperturen, (26;36), die Zwischenräume (25;35) zwischen den interdigitalen Wandlern (23;24;33;34) und die Synchronwellenlängen in den Zweitor-Oberflächenwellenresonatoren (2;3) so gewählt sind, dass die Oszillatorfrequenz bei einer vorgegebenen Temperatur einer vorgegebenen Frequenz entspricht.

5. Oszillator nach Anspruch 1, **dadurch gekennzeichnet, dass** die frequenzbestimmenden Elemente akustische Oberflächenwellenresonatoren (2;3) sind, bei denen der interdigitale Wandler (24 bzw. 34) zwischen je zwei Reflektoren (21;22;31;32) angeordnet ist, wobei das Verhältnis der Aperturen der Wandler (24;34) und das Verhältnis der Längen der Koppelelemente (23;33) in Richtung senkrecht zu den Zinkenkanten der Wandler (29;34) und den Streifen der Reflektoren (21;22; 31;33) so gewählt sind, dass die Variation der Oszillatorfrequenz im bestimmungsgemäßen Temperaturbereich des Oszillators minimal ist.

6. Oszillator nach Anspruch 1, **dadurch gekennzeichnet, dass** beide Oberflächenwellenresonatoren (2;3) mit Substraten der gleichen Kristallart aufgebaut sind.

7. Oszillator nach Anspruch 1, **dadurch gekennzeichnet, dass** die Substrate der Oberflächenwellenresonatoren (2;3) verschiedenen Kristallarten angehören.

8. Oszillator nach Anspruch 6, **dadurch gekennzeichnet, dass** die Oberflächenwellenresonatoren (2;3) unterschiedliche Ausbreitungsrichtungen für akustische Oberflächenwellen auf ein und demselben Kristallschnitt benutzen.

9. Oszillator nach Anspruch 1 oder 7, **dadurch gekennzeichnet, dass** die Oberflächenwellenresonatoren (2;3) auf separaten Substraten angeordnet sind.

10. Oszillator nach Anspruch 1, **dadurch gekennzeichnet, dass** die Elektrodenstrukturen beider Oberflächenwellenresonatoren (2;3) auf einem gemeinsamen Substrat (1) angeordnet sind.

11. Oszillator nach Anspruch 1, **dadurch gekennzeichnet, dass** die Kristallarten, die Kristallschnitte sowie die Ausbreitungsrichtungen der Zweitor-Oberflächenwellenresonatoren (2;3) für akustische Oberflächenwellen so gewählt sind, dass die Temperaturabhängigkeiten $f_1(T)$ und $f_2(T)$ der Synchronfrequenz $f_1$ bzw. $f_2$ des ersten beziehungsweise zweiten Zweitor-Oberflächenwellenresonators (2;3) die Gleichung

$$V\big(f_1(T),\ f_2(T)\big)\ =\ -\big(\partial\varphi\ /\ \partial f_2\big)\ /\big(\partial\varphi\ /\ \partial f_1\big)$$

erfüllen,
mit

$$V\ =\ \big(df_1\ /\ dT\big)\ /\big(df_2\ /\ dT\big)\big|_{T=T_1}$$

oder mit

$$V\ =\ \big\lfloor\big(f_{1,max}\ -\ f_{1,min}\big)\ /\ \Delta T_1\big\rfloor\ /\big\lfloor\big(f_{2,max}\ -\ f_{2,min}\big)\ /\ \Delta T_2\big\rfloor$$

und mit

$$\Delta T_{1,2}\ =\ T_{1,2,max}\ -\ T_{1,2,min}\ ,$$

wobei $\varphi$ die Phase des Verbundes der Zweitor-Oberflächenwellenresonatoresonatoren (2;3), $f_{1,2,max}$ die im betrachteten Temperaturbereich maximale Synchronfrequenz des ersten beziehungsweise zweiten Zweitor-Oberflächenwellenresonators (2; 3), $f_{1,2,min}$ die im betrachteten Temperaturbereich minimale Synchronfrequenz des ersten bzw. zweiten Zweitor-Oberflächenwellenresonators (2; 3) und $T_{1,2,max}$ und $T_{1,2,min}$ diejenigen Temperaturen sind, bei denen die entsprechenden Extremwerte der Synchronfrequenzen auftreten und $T_1$ eine Temperatur im betrachteten Temperaturbereich ist.

12. Oszillator nach Anspruch 1, **dadurch gekennzeichnet, dass** zwischen den interdigitalen Wandlern (23;24;33;34) wenigstens eines Zweitor-Oberflächenwellenresonators (2;3) ein Zwischenreflektor angeordnet ist.

13. Oszillator nach Anspruch 1, **dadurch gekennzeichnet, dass** sich einer der interdigitalen Wandler (23;24;33;34) durch seine Polarität von den übrigen unterscheidet.

14. Oszillator nach Anspruch 1, **dadurch gekennzeichnet, dass** in beiden Zweitor-Oberflächenwellenresonatoren (2; 3) der Temperaturkoeffizient der Synchronfrequenz gleicher Ordnung dominiert.

15. Oszillator nach Anspruch 1, **dadurch gekennzeichnet, dass** in beiden Zweitor-Oberflächenwellenresonatoren (2; 3) der Temperaturkoeffizient der Synchronfrequenz erster Ordnung dominiert.

16. Oszillator nach Anspruch 1, **dadurch gekennzeichnet, dass** in beiden Zweitor-Oberflächenwellenresonatoren (2; 3) der Temperaturkoeffizient der Synchronfrequenz zweiter Ordnung dominiert.

17. Oszillator nach Anspruch 1, **dadurch gekennzeichnet, dass** die Zweitor-Oberflächenwellenresonatoren (2;3) ähnliche Temperaturabhängigkeiten der Synchronfrequenz haben, wobei die Ähnlichkeit darin besteht, dass die Temperaturabhängigkeit der Synchronfrequenz des einen Zweitor-Oberflächenwellenresonators (2;3) durch Multiplikation mit einem konstanten Faktor der Temperaturabhängigkeit der Synchronfrequenz des jeweils anderen Zweitor-Oberflächenwellenresonators (2;3) so angenähert werden kann, dass die Differenz der Temperaturabhängigkeiten der Synchronfrequenz im gesamten betrachteten Temperaturbereich wesentlich kleiner ist als diese Temperaturabhängigkeit jeder der beiden Zweitor-Oberflächenwellenresonatoren (2;3).

18. Oszillator nach Anspruch 1, **dadurch gekennzeichnet, dass** die Synchronwellenlängen in den Zweitor-Oberflächenwellenresonatoren (2;3) so gewählt sind, dass die Zweitor-Oberflächenwellenresonatoren (2;3) trotz unterschiedlicher Phasengeschwindigkeiten die gleiche Resonanzfrequenz haben.

19. Oszillator nach Anpruch 1, **dadurch gekennzeichnet, dass** die Oberflächenwellenresonatoren (2;3) als Koppelelement einen Koppelwandler (23;33) enthalten und der Koppelwandler (23) des ersten Oberflächenwellenresonators (2) mit dem Koppelwandler (33) des jeweils zweiten Oberflächenwellenresonators (3) über zwei elektrische Verbindungen (5;6) miteinander verbunden sind.

20. Oszillator nach Anspruch 1, **dadurch gekennzeichnet, dass** sich die Aperturen der Koppelwandler (23;33) voneinander unterscheiden und die Zinkenzahlen der Koppelwandler (23;33) gleich sind.

21. Oszillator nach Anspruch 1, **dadurch gekennzeichnet, dass** sich die Zinkenzahlen der Koppelwandler (23;33) voneinander unterscheiden und die Aperturen der Koppelwandler (23;33) gleich sind.

22. Oszillator nach Anspruch 1, **dadurch gekennzeichnet, dass** die Koppelwandler (23;33) mehr Zinken enthalten als der Wandler (24;34) desjenigen Oberflächenwellenresonators (2;3), zu dem der jeweilige Koppelwandler (23; 33) gehört.

23. Oszillator nach Anspruch 1, **dadurch gekennzeichnet, dass** zwischen die elektrischen Verbindungen (5;6), die die Koppelwandler (23;33) verschiedener Oberflächenwellenresonatoren (2;3) verbinden, eine Induktivität (7), bezeichnet als Koppelinduktivität, geschaltet ist.

24. Oszillator nach Anspruch 1, **dadurch gekennzeichnet, dass** zwischen die elektrischen Verbindungen (5;6), die die Koppelwandler (23;33) verschiedener Oberflächenwellenresonatoren (2;3) verbinden, eine Kapazität, bezeichnet als Koppelkapazität, geschaltet ist.

25. Oszillator nach Anspruch 1, **dadurch gekennzeichnet, dass** mindestens einer der Koppelwandler (23;33) mindestens eine Gruppe aufeinanderfolgender Zinken enthält, welche aus einer geraden Anzahl Zinken mit gleicher Polarität besteht.

26. Oszillator nach 1, **dadurch gekennzeichnet, dass** der Kristallschnitt ein ST-Schnitt von Quarz ist und dass die Richtung senkrecht zu den Zinken der Wandler und zu den Reflektorstreifen für den einen Oberflächenwellenresonator (2) um einen Winkel zwischen 0° und 45° und für den anderen Oberflächenwellenresonator (3) um einen Winkel >45° zur kristallografischen X-Achse von Quarz geneigt ist.

**27.** Oszillator nach Anspruch 1, **dadurch gekennzeichnet, dass** die Koppelelemente (23; 33) beider Oberflächenwellenresonatoren (2;3) einen Multistreifenkoppler bilden.

**28.** Oszillator nach Anspruch 1, **dadurch gekennzeichnet, dass** die Zinkenperiode der Wandler (24; 34), die Streifenperiode der Reflektorstreifen, die Abstände der Wandler (24; 34) zu den Koppelelementen (23; 33) und zu den Reflektoren (21;22;31;32) sowie die Dicke der Elektrodenschicht der Oberflächenwellenresonatoren (2; 3) so gewählt sind, dass deren Resonanzen an einer vorgegebenen Temperatur einen vorgegebenen Frequenzabstand haben.

**29.** Oszillator nach Anspruch 28, **dadurch gekennzeichnet, dass** der vorgegebene Frequenzabstand gleich null ist.

**Claims**

**1.** Oscillator, containing a group of two frequency-determining elements, with each element containing at least one interdigital transducer (24; 34) for surface acoustic waves, and with feedback being provided from the output (9) to the input (8) of the group, which feedback contains an amplifier, and with the frequency-determining elements (2; 3) differing from one another by the temperature dependency of the synchronous frequency, **characterized in that** the frequency-determining elements are acoustic two-port surface acoustic wave resonators (2; 3), in each of which two interdigital transducers (23; 24; 33; 34) are arranged between two reflectors (21; 22; 31; 32) and the two-port surface acoustic wave resonators (2; 3) contain the coupling elements (23; 33) for mutual coupling of their wave fields, or interdigital transducers in the two-port surface acoustic wave resonators (2; 3) are those objects which are connected to one another in parallel as a consequence of the group, with the first-order temperature coefficient of the synchronous frequency of each of the two surface acoustic wave resonators (2; 3) not being equal to zero and differing in the mathematical sign from this temperature coefficient of the respective other two-port surface acoustic wave resonator, or with the second-order temperature coefficient of the synchronous frequency of each of the two surface acoustic wave resonators (2; 3) not being equal to zero, and the first-order temperature coefficients, with respect to a predetermined temperature, being equal to zero.

**2.** Oscillator according to Claim 1, **characterized in that** the ratio of the apertures of the interdigital transducers (24; 34) and the ratio of the lengths in the direction at right angles to the tine edges of the interdigital transducers (24; 34) and the strips of the reflectors (21; 22; 31; 32) of those objects (23; 33) of different frequency-determining elements which are connected to one another as a consequence of the group are chosen such that the change in the oscillator frequency is minimal in the temperature range for which the oscillator is intended.

**3.** Oscillator according to Claim 1, **characterized in that** each of the frequency-determining elements contains two interdigital transducers (23; 24; 33; 34) for surface acoustic waves, with interdigital transducers being those objects which are connected to one another in parallel as a consequence of the group.

**4.** Oscillator according to Claim 1, **characterized in that** two interdigital transducers (23; 24; 33; 34) in the acoustic two-port surface acoustic wave resonators (2; 3) are in each case arranged between two reflectors (21; 22; 31; 32), and the two-port surface acoustic wave resonators (2; 3) differ in the aperture (26; 36) and the intermediate space (25; 35) between the interdigital transducers (23; 24 and 33; 34, respectively), with the apertures (26; 36), the intermediate spaces (25; 35) between the interdigital transducers (23; 24; 33; 34) and the synchronous wavelengths in the two-port surface acoustic wave resonators (2; 3) being chosen such that the oscillator frequency at a predetermined temperature corresponds to a predetermined frequency.

**5.** Oscillator according to Claim 1, **characterized in that** the frequency-determining elements are surface acoustic wave resonators (2; 3) in which the interdigital transducers (24 and 34, respectively) are arranged between in each case two reflectors (21; 22; 31; 32), with the ratio of the apertures of the transducers (24; 34) and the ratio of the lengths of the coupling elements (23; 33) in the direction at right angles to the tine edges of the transducers (24; 34) and the strips of the reflectors (21; 22; 31; 32) being chosen such that the variation of the oscillator frequency is minimal in the operating temperature range of the oscillator.

**6.** Oscillator according to Claim 1, **characterized in that** both surface acoustic wave resonators (2; 3) are constructed with substrates of the same crystal type.

**7.** Oscillator according to Claim 1, **characterized in that** the substrates of the surface acoustic wave resonators (2;

**10**

3) belong to different crystal types.

8. Oscillator according to Claim 6, **characterized in that** the surface acoustic wave resonators (2; 3) use different propagation directions for surface acoustic waves on one and the same crystal cut.

9. Oscillator according to Claim 1 or 7, **characterized in that** the surface acoustic wave resonators (2; 3) are arranged on separate substrates.

10. Oscillator according to Claim 1, **characterized in that** the electrode structures of both surface acoustic wave resonators (2; 3) are arranged on a common substrate (1).

11. Oscillator according to Claim 1, **characterized in that** the crystal types, the crystal cuts and the propagation directions of the two-port surface acoustic wave resonators (2; 3) for surface acoustic waves are chosen such that the temperature dependencies $f_1(T)$ and $f_2(T)$ of the synchronous frequency $f_1$ and $f_2$, respectively of the first and second two-port surface acoustic wave resonators (2; 3), respectively, satisfy the equation

$$V(f_1(T), f_2(T)) = -(\partial\varphi / \partial f_2) / (\partial\varphi / \partial f_1)$$

where V =

$$V = (df_1 / dT) / (df_2 / dT)_{T=T_1}$$

or where

$$V = \left[\left(f_{1,max} - f_{1,min}\right) / \Delta T_1\right] / \left[\left(f_{2,max} - f_{2,min}\right) / \Delta T_2\right]$$

and where

$$\Delta T_{1,2} = T_{1,2,max} - T_{1,2,min} ,$$

where $\varphi$ is the phase of the group of the two-port surface acoustic wave resonators (2; 3), $f_{1,2,max}$ is the maximum synchronous frequency, in the temperature range under consideration, of the first or second respective two-port surface acoustic wave resonator (2; 3), $f_{1,2,min}$ is the minimum synchronous frequency, in the temperature range under consideration, of the first or second respective two-port surface acoustic wave resonator (2; 3) and $T_{1,2,max}$ and $T_{1,2,min}$ are those temperatures at which the corresponding extreme values of the synchronous frequencies occur, and $T_1$ is a temperature in the temperature range under consideration.

12. Oscillator according to Claim 1, **characterized in that** an intermediate reflector is arranged between the interdigital transducers (23; 24; 33; 34) of at least one two-port surface acoustic wave resonator (2; 3).

13. Oscillator according to Claim 1, **characterized in that** one of the interdigital transducers (23; 24; 33; 34) has a different polarity to the others.

14. Oscillator according to Claim 1, **characterized in that** the temperature coefficient of the synchronous frequency of the same order dominates in both two-port surface acoustic wave resonators (2; 3).

15. Oscillator according to Claim 1, **characterized in that** the temperature coefficient of the first-order synchronous frequency dominates in both two-port surface acoustic wave resonators (2; 3).

16. Oscillator according to Claim 1, **characterized in that** the temperature coefficient of the second-order synchronous frequency dominates in both two-port surface acoustic wave resonators (2; 3).

17. Oscillator according to Claim 1, **characterized in that** the two-port surface acoustic wave resonators (2; 3) have similar temperature dependencies of the synchronous frequency, with the similarity consisting **in that** the temperature dependency of the synchronous frequency of one two-port surface acoustic wave resonator (2; 3) can be approximated by multiplying the temperature dependency of the synchronous frequency of the respective other two-port surface acoustic wave resonator (2; 3) by a constant factor such that the difference between the temperature dependencies of the synchronous frequency is considerably less throughout the entire temperature range under consideration than this temperature dependency of each of the two two-port surface acoustic wave resonators (2; 3).

18. Oscillator according to Claim 1, **characterized in that** the synchronous wavelengths in the two-port surface acoustic wave resonators (2; 3) are chosen such that the two-port surface acoustic wave resonators (2; 3) have the same resonant frequency despite having different phase velocities.

19. Oscillator according to Claim 1, **characterized in that** the surface acoustic wave resonators (2; 3) contain a coupling transducer (23; 33) as a coupling element, and the coupling transducer (23) of the first surface acoustic wave resonator (2) together with the coupling transducer (33) of the respective second surface acoustic wave resonator (3) are connected to one another via two electrical connections (5; 6).

20. Oscillator according to Claim 1, **characterized in that** the apertures of the coupling transducers (23; 33) differ from one another, and the coupling transducers (23; 33) have the same numbers of tines.

21. Oscillator according to Claim 1, **characterized in that** the coupling transducers (23; 33) have different numbers of tines from one another, and the apertures of the coupling transducers (23; 33) are the same.

22. Oscillator according to Claim 1, **characterized in that** the coupling transducers (23; 33) contain more tines than the transducer (24; 34) of that surface acoustic wave resonator (2; 3) to which the respective coupling transducer (23; 33) belongs.

23. Oscillator according to Claim 1, **characterized in that** an inductance (7) referred to as a coupling inductance, is connected between the electrical connections (5; 6) which connect the coupling transducers (23; 33) of different surface acoustic wave resonators (2; 3).

24. Oscillator according to Claim 1, **characterized in that** a capacitance, referred to as a coupling capacitance, is connected between the electrical connections (5; 6) which connect the coupling transducers (23; 33) of different surface acoustic wave resonators (2; 3).

25. Oscillator according to Claim 1, **characterized in that** at least one of the coupling transducers (23; 33) contains at least one group of successive tines, comprising an even number of tines with the same polarity.

26. Oscillator according to Claim 1, **characterized in that** the crystal cut is a quartz ST cut, and **in that** the direction at right angles to the tines of the transducers and at right angles to the reflector strips for one surface acoustic wave resonator (2) is inclined through an angle of between 0° and 45°, and that for the other surface acoustic wave resonator (3) is inclined through an angle of > 45° with respect to the crystallographic X-axis of quartz.

27. Oscillator according to Claim 1, **characterized in that** the coupling elements (23; 33) of both surface acoustic wave resonators (2; 3) form a multistrip coupler.

28. Oscillator according to Claim 1, **characterized in that** the tine period of the transducers (24; 34), the strip period of the reflector strips, the distances of the transducers (24; 34) from the coupling elements (23; 33) and from the reflectors (21; 22; 31; 32) as well as the thickness of the electrode layer of the surface acoustic wave resonators (2; 3) are chosen such that their resonances have a predetermined frequency separation at a predetermined temperature.

29. Oscillator according to Claim 28, **characterized in that** the predetermined frequency separation is equal to zero.

**Revendications**

1. Oscillateur qui contient un composite constitué de deux éléments de définition de fréquence, chaque élément contenant au moins un convertisseur internumérique (24; 34) d'ondes acoustiques de surface et une rétroaction étant prévue entre la sortie (9) et l'entrée (8) du composite et contenant un amplificateur, les éléments (2; 3) de définition de la fréquence différant l'un de l'autre par leur dépendance de la fréquence de synchronisation vis-à-vis de la température, **caractérisé en ce que** les éléments de définition de fréquence sont des résonateurs (2; 3) d'ondes de surface à double porte dans lesquels deux convertisseurs internumériques (23; 24; 33; 34) sont disposés entre deux réflecteurs (21; 22; 31; 32) et les résonateurs (2; 3) d'ondes de surface à double porte contiennent des éléments de couplage (23; 33) qui couplent mutuellement leurs champs d'onde, les convertisseurs internumériques prévus dans les deux résonateurs (2; 3) d'ondes de surface à double porte sont les objets qui dans le composite sont raccordés l'un à l'autre en parallèle, le coefficient de température du premier ordre de la fréquence de synchronisation de chacun des deux résonateurs (2; 3) d'ondes de surface étant différent de zéro et ayant un signe différent de celui du coefficient de température de l'autre des deux résonateurs (2; 3) d'ondes de surface ou le coefficient de température du deuxième ordre de la fréquence de synchronisation de chacun des deux résonateurs (2; 3) d'ondes de surface étant différent de zéro et les coefficients de température du premier ordre étant nuls pour une température prédéterminée.

2. Oscillateur selon la revendication 1, **caractérisé en ce que** le rapport entre les ouvertures des convertisseurs internumériques (24; 34) et le rapport des longueurs dans la direction perpendiculaire aux bords des dents des convertisseurs internumériques (24; 34) et des bandes de réflexion (21; 22; 31; 32) des objets (23; 33) des différents éléments de détermination de la fréquence reliés les uns aux autres dans le composite sont sélectionnés de telle sorte que la modification de la fréquence d'oscillation soit minimale dans la plage de température pour laquelle l'oscillateur est défini.

3. Oscillateur selon la revendication 1, **caractérisé en ce que** chacun des éléments de définition de la fréquence contient deux convertisseurs internumériques (23; 24; 33; 34) d'ondes acoustiques de surface, les convertisseurs internumériques étant les objets qui sont reliés mutuellement dans le circuit en parallèle dans le composite.

4. Oscillateur selon la revendication 1, **caractérisé en ce que** parmi les résonateurs acoustiques (2; 3) d'ondes de surface à double porte, deux convertisseurs internumériques (23; 24; 33; 34) sont disposés entre deux réflecteurs (21; 22; 31; 32), les résonateurs (2; 3) d'ondes de surface à double porte différant par leur ouverture (26; 36) et l'espace intermédiaire (25; 35) entre les convertisseurs internumériques (23; 24 ou 33; 34), les ouvertures (26; 36), les espaces intermédiaires (25; 35) entre les convertisseurs internumériques (23; 24; 33; 34) et les longueurs d'onde de synchronisation des résonateurs (2; 3) d'ondes de surface à double porte étant sélectionnés de telle sorte qu'à une température prédéterminée, la fréquence d'oscillation corresponde à une fréquence prédéterminée.

5. Oscillateur selon la revendication 1, **caractérisé en ce que** les éléments de détermination de la fréquence sont des résonateurs acoustiques (2; 3) d'ondes de surface dans lesquels le convertisseur internumérique (24 ou 34) est disposé entre deux réflecteurs (21; 22; 31; 32), le rapport entre les ouvertures des convertisseurs (24; 34) et le rapport entre les longueurs des éléments de couplage (23; 33) dans la direction perpendiculaire aux bords des dents des convertisseurs (24; 34) et les bandes de réflexion (21; 22; 31; 32) étant sélectionnés de telle sorte que la variation de la fréquence d'oscillation soit minimale dans la plage de température pour laquelle l'oscillateur est défini.

6. Oscillateur selon la revendication 1, **caractérisé en ce que** les deux résonateurs (2; 3) d'ondes de surface sont constitués de substrats de même type cristallin.

7. Oscillateur selon la revendication 1, **caractérisé en ce que** les substrats des résonateurs (2; 3) d'ondes de surface appartiennent à des types cristallins différents.

8. Oscillateur selon la revendication 6, **caractérisé en ce que** les résonateurs (2; 3) d'ondes de surface utilisent différentes directions de propagation des ondes acoustiques de surface sur un seul et même plan cristallin.

9. Oscillateur selon les revendications 1 ou 7, **caractérisé en ce que** les résonateurs (2; 3) d'ondes de surface sont disposés sur des substrats séparés.

10. Oscillateur selon la revendication 1, **caractérisé en ce que** les structures d'électrodes des deux résonateurs (2;

3) d'ondes de surface sont disposées sur un substrat (1) commun.

**11.** Oscillateur selon la revendication 1, **caractérisé en ce que** les types cristallins, les plans cristallins ainsi que les directions de propagation des résonateurs (2; 3) d'ondes de surface à double porte pour ondes acoustiques de surface sont sélectionnés de telle sorte que les dépendances vis-à-vis de la température $f_1(T)$ et $f_2(T)$ de la fréquence de synchronisation $f_1$ ou $f_2$ du premier ou du deuxième résonateur (2; 3) d'ondes de surface à double porte satisfont l'équation :

$$V\bigl(f_1(T),\ f_2(T)\bigr)\ =\ -\bigl(\partial\varphi\ /\ \partial f_2\bigr)\ /\bigl(\partial\varphi\ /\ \partial f_1\bigr)$$

avec :

$$V\ =\ \bigl(df_1\ /\ dT\bigr)\ /\bigl(df_2\ /\ dT\bigr)_{T=T_1}$$

ou avec :

$$V\ =\ \bigl[\bigl(f_{1,max}\ -\ f_{1,min}\bigr)\ /\ \Delta T_1\bigr]\ /\bigl[\bigl(f_{2,max}\ -\ f_{2,min}\bigr)\ /\ \Delta T_2\bigr]$$

et avec :

$$\Delta T_{1,2}\ =\ T_{1,2,max}\ -\ T_{1,2,min}\ ,$$

dans lesquelles $\varphi$ représente la phase de l'ensemble constitué des résonateurs (2; 3) d'ondes de surface à double porte, $f_{1,2,max}$ la fréquence de synchronisation maximale dans la plage de température envisagée du premier ou du deuxième résonateur (2; 3) d'ondes de surface à double porte, $f_{1,2,min}$ la fréquence de synchronisation minimale dans la plage de température considérée du premier et du deuxième résonateur (2; 3) d'ondes de surface à double porte, $T_{1,2,max}$ et $T_{1,2,min}$ les températures qui correspondent aux valeurs maximales des fréquences de synchronisation et $T_1$ une température comprise dans la plage de température considérée.

**12.** Oscillateur selon la revendication 1, **caractérisé en ce qu'**entre les convertisseurs internumériques (23; 24; 33; 34) d'au moins un résonateur (2; 3) d'ondes de surface à double porte, un réflecteur intermédiaire est disposé.

**13.** Oscillateur selon la revendication 1, **caractérisé en ce que** l'un des convertisseurs internumériques (23; 24; 33; 34) a une polarité différente de celle des autres.

**14.** Oscillateur selon la revendication 1, **caractérisé en ce que** le coefficient de température de la fréquence de synchronisation de même ordre est dominant dans les deux résonateurs (2; 3) d'ondes de surface à double porte.

**15.** Oscillateur selon la revendication 1, **caractérisé en ce que** le coefficient de température de la fréquence de synchronisation du premier ordre est dominant dans les deux résonateurs (2; 3) d'ondes de surface à double porte.

**16.** Oscillateur selon la revendication 1, **caractérisé en ce que** le coefficient de température de la fréquence de synchronisation du deuxième ordre est dominant dans les deux résonateurs (2; 3) d'ondes de surface à double porte.

**17.** Oscillateur selon la revendication 1, **caractérisé en ce que** les résonateurs (2; 3) d'ondes de surface à double porte ont des dépendances similaires de la fréquence de synchronisation par rapport à la température, la similarité consistant **en ce que** la dépendance de la fréquence de synchronisation vis-à-vis de la température du résonateur (2; 3) d'ondes de surface à double porte peut être approchée par multiplication par un facteur constant de la dépendance de la fréquence de synchronisation vis-à-vis de la température de l'autre résonateur (2; 3) d'ondes de surface à double porte, de telle sorte que la différence entre les dépendances de la fréquence de synchronisation vis-à-vis de la température dans toute la plage de température considérée est considérablement plus petite que cette dépendance vis-à-vis de la température de chacun des deux résonateurs (2; 3) d'ondes de surface à double porte.

18. Oscillateur selon la revendication 1, **caractérisé en ce que** les longueurs d'onde de synchronisation des deux résonateurs (2; 3) d'ondes de surface à double porte sont sélectionnées de telle sorte que malgré qu'ils ont des vitesses de phase différentes, les deux résonateurs (2; 3) d'ondes de surface à double porte aient la même fréquence de résonance.

19. Oscillateur selon la revendication 1, **caractérisé en ce que** les résonateurs (2; 3) d'ondes de surface contiennent comme élément de couplage un convertisseur de couplage (23; 33), le convertisseur de couplage (23) du premier résonateur (2) d'ondes de surface étant relié au convertisseur de couplage (33) du deuxième résonateur (3) d'ondes de surface par deux conducteurs électriques (5; 6).

20. Oscillateur selon la revendication 1, **caractérisé en ce que** les ouvertures des convertisseurs de couplage (23; 33) sont différentes l'une de l'autre et que les nombres de dents des convertisseurs de couplage (23; 33) sont identiques.

21. Oscillateur selon la revendication 1, **caractérisé en ce que** les nombres de dents des convertisseurs de couplage (23; 33) sont différents l'un de l'autre et **en ce que** les ouvertures des convertisseurs de couplage (23; 33) sont identiques.

22. Oscillateur selon la revendication 1, **caractérisé en ce que** les convertisseurs de couplage (23; 33) contiennent davantage de dents que le convertisseur (24; 34) du résonateur (2; 3) d'ondes de surface auquel le convertisseur de couplage (23; 33) appartient.

23. Oscillateur selon la revendication 1, **caractérisé en ce qu'**une inductance (7) appelée inductance de couplage est raccordée entre les conducteurs électriques (5; 6) qui relient les convertisseurs de couplage (23; 33) de différents résonateurs (2; 3) d'ondes de surface.

24. Oscillateur selon la revendication 1, **caractérisé en ce qu'**une capacité appelée capacité de couplage est raccordée entre les conducteurs électriques (5; 6) qui relient les convertisseurs de couplage (23; 33) de différents résonateurs (2; 3) d'ondes de surface.

25. Oscillateur selon la revendication 1, **caractérisé en ce qu'**au moins l'un des deux convertisseurs de couplage (23; 33) contient au moins un groupe de dents successives qui est constitué d'un nombre pair de dents de même polarité.

26. Oscillateur selon la revendication 1, **caractérisé en ce que** le plan cristallin est un plan ST du quartz et **en ce que** la direction perpendiculaire aux dents des convertisseurs et aux rubans réflecteurs d'un résonateur (2) d'ondes de surface forme un angle compris entre 0 ° et 45 ° et pour l'autre résonateur (3) d'ondes de surface, un angle > 45 ° par rapport à l'axe cristallographique X du quartz.

27. Oscillateur selon la revendication 1, **caractérisé en ce que** les éléments de couplage (23; 33) des deux résonateurs (2; 3) d'ondes de surface forment un coupleur à plusieurs bandes.

28. Oscillateur selon la revendication 1, **caractérisé en ce que** la période des bandes des convertisseurs (24; 34), la période des bandes de réflexion, la distance entre les convertisseurs (24; 34) et les éléments de couplage (23; 33) et les réflecteurs (21; 22; 31; 32) ainsi que l'épaisseur de la couche d'électrodes des résonateurs (2; 3) d'ondes de surface sont sélectionnées de telle sorte que leurs résonances ont un écart en fréquence prédéterminé à une température prédéterminée.

29. Oscillateur selon la revendication 28, **caractérisé en ce que** l'écart en fréquence prédéterminé est égal à zéro.

Fig. 1

**Fig. 2**

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4193045 A

**In der Beschreibung aufgeführte Nicht-Patentliteratur**

- **T. I. BROWNING ; M. F. LEWIS.** A novel technique for improving the temperature stability of SAW/SSBW devices. *IEEE Ultrasonics Symposium,* 1978, vol. 1, 474-477

- **W. BUFF ; M. RUSKO ; T. VANDAHL ; M. GOROLL ; F. MÖLLER.** *IEEE Ultrasonics Symposium,* 1996, vol. 2, 343-346